Europäisches Patentamt

European Patent Office

Office européen des brevets

(19)

(11) Veröffentlichungsnummer: **0 269 811 B1**

(12) **EUROPÄISCHE PATENTSCHRIFT**

(45) Veröffentlichungstag der Patentschrift: 14.08.91

(51) Int. Cl.⁵: **H03K 19/177**

(21) Anmeldenummer: 87114419.2

(22) Anmeldetag: 02.10.87

(54) In integrierter Technik hergestellter Baustein zur Erstellung integrierter Schaltungen.

(30) Priorität: 04.12.86 DE 3641452

(43) Veröffentlichungstag der Anmeldung:
08.06.88 Patentblatt 88/23

(45) Bekanntmachung des Hinweises auf die
Patenterteilung:
14.08.91 Patentblatt 91/33

(84) Benannte Vertragsstaaten:
AT CH DE FR GB IT LI NL SE

(56) Entgegenhaltungen:

IBM TECHNICAL DISCLOSURE BULLETIN
Band 24, Nr. 6, November 1981, Seiten 2971 -
2973; P.E. ALLARD et al.: "Variable Multifold
Programmable Logic Array"

(73) Patentinhaber: Siemens Nixdorf Informationssysteme Aktiengesellschaft
Fürstenallee 7
W-4790 Paderborn(DE)

(72) Erfinder: Brockmann, Werner
Burgstrasse 8
W-4791 Altenbeken(DE)

(74) Vertreter: Schaumburg, Thoenes & Englaender
Mauerkircherstrasse 31 Postfach 86 07 48
W-8000 München 86(DE)

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen in integrierter Technik her-gestellten Baustein zur Erstellung integrierter Schaltungen gemäß dem Oberbegriff des Anspruchs 1.

Als Kopplungselemente werden dabei solche Elemente bezeichnet, die im aktivierten Zustand den Schaltzustand eines Leiters ggf. in invertiertem Zustand in der Form auf einen kreuzenden Leiter übertragen, daß auf diesem logische Verknüpfungen durchgeführt werden können.

Bausteine mit Verknüpfungsfeldern oder Logik-Arrays zur Darstellung logischer Schaltungen sind in vielfältigen Ausführungsformen, insbesondere mit programmierbaren Kopplungselementen bekannt. Eine Programmierung kann mit Hilfe von Masken bei der Herstellung des Bausteines oder auch nachträglich beispielsweise durch die Bearbeitung des Bausteines mittels eines Laserstrahles, vorzugsweise aber auf elektrischem Wege erfolgen. Die Array-Struktur der Verknüpfungsfelder bietet den Vorteil, daß in ihnen alle denkbaren booleschen Verknüpfungen der Eingangsgrößen untereinander und ggf. mit zurückgeführten Signalen vorgenommen werden können. Die Programmierbarkeit erlaubt dabei die Anpassung der integrierten Schaltung an die jeweilige Aufgabe, nachdem die integrierte Schaltung vollständig (bei elektrischer Programmierung) bzw. fast vollständig (bei Maskenprogrammierung)gefertigt ist. Das ermöglicht die kostengünstige Herstellung der Bausteine durch hohe Stückzahlen, selbst wenn wenige integrierte Schaltungen je Aufgabe benötigt werden. Die Spezifizierung der Schaltung entsprechend der jeweiligen Aufgabe wird ausgehend von einer logischen Beschreibung durch Software-Werkzeuge unterstützt.

Die Umsetzung logischer Funktionen innerhalb einer Array-Struktur geschieht in Form einer kombinierten Anordnung eines UND- und eines ODER-Arrays. Vorzugsweise wird in den Arrays dabei von WIRED-UND-, WIRED-ODER, WIRED-NOR- oder WIRED-NAND-Verknüpfungen Gebrauch gemacht, die beispielsweise durch den Einsatz von bipolaren Transistoren, Feldeffekttransistoren oder Dioden als Kopplungselemente in Verbindung mit sogenannten PULL-UP-Elementen bzw. PULL-DOWN-Elementen (beispielsweise Widerstände) in entsprechender Anordnung realisiert werden. Dabei lassen sich aufgrund der booleschen Äquivalenz durch Invertierungen die UND-oder ODER-Funktionen auch durch NAND- bzw. NOR-Funktionen darstellen.

Außerdem werden für anwenderspezifische integrierte Schaltkreise auch Gate-Arrays angewandt. Als Gate-Arrays werden vorgefertigte Halbleiterbausteine mit in Zeilen angeordneten Gattern bezeichnet, die erst in einem abschließenden Metallisierungsschritt entsprechend den vom Anmelder gewünschten Funktionen verdrahtet werden. Das erlaubt die kostengünstige Herstellung von vorgefertigten gleichartigen Halbleiterbausteinen in hohen Stückzahlen, die erst dann entsprechend den Wünschen des jeweiligen Anwenders personalisiert werden .

Gate-Arrays besitzen zwar eine hohe Flexibilität, bedingen aber komplexe Entwicklungswerkzeuge, hohe Entwicklungskosten und lange Wartezeiten zwischen dem Abschluß des Entwurfs und der Lieferung der ersten Prototypen. Ihr Einsatz lohnt sich deshalb erst ab einem gewissem Umfang der zu realisierenden Schaltung. Für bestimmte Verknüpfungen sind Logik-Arrays hinsichtlich der Verarbeitungsgeschwindigkeit und der Einfachheit der Funktionsbeschreibung günstiger. Ihr regelmäßiger Aufbau vereinfacht die Integration erheblich.

Zwischen Gate-Arrays und Logik-Arrays klafft demnach eine Lücke, da es mit den bisher bekannten Verknüpfungsfeldern kaum oder nur in wenig effektiver Weise möglich ist, mehrstufige Logikschaltungen innerhalb eines Verknüpfungsfeldes unterzubringen. In der Regel sind mehrere Verknüpfungsfelder und ggf. zusätzliche aktive Elemente an deren Peripherie erforderlich, um mehrstufige bzw. zusammengesetzte Logikstrukturen darzustellen. Bei Beibehaltung der Flexibilität der Anordnung, d.h. der Möglichkeit zur Darstellung möglichst vieler unterschiedlicher logischer Schaltungen innerhalb eines Verknüpfungsfeldes, kann dies zu einem großen Bedarf an Chipfläche führen. Der Bedarf an Substratfläche beeinflußt jedoch in erheblichem Maße die Herstellungskosten des Schaltungsbausteines. Der Aufbau des Chips wird außerdem unregelmäßiger und damit schlechter testbar und integrierbar.

Der Erfindung liegt die Aufgabe zugrunde, einen Baustein der eingangs genannten Art mit einer Struktur anzugeben, die sehr regelmäßig in ihrem Aufbau und für Schaltungen unterschiedlicher Art, Komplexität und Größe geeignet ist und die unabhängig vom Herstellungsprozeß und der Art der Speicherung der Personalisierung verwendbar ist.

Diese Aufgabe wird erfindungsgemäß durch die im Kennzeichen des Anspruchs 1 angegebenen Merkmale gelöst.

An den Kreuzungspunkten, an denen sich je zwei Kopplungselemente mit um $90^\circ$ gegeneinander gedrehter Wirkungsrichtung befinden, kann eine Verknüpfung sowohl auf vertikalen als auch auf horizontalen Leitern erfolgen, so daß die betreffenden Leiter wahlweise zur Realisierung einer UND-Funktion oder einer ODER-Funktion eingesetzt werden können. Diese Ausbildung des Verknüpfungsfeldes ergibt bei

EP 0 269 811 B1

einem sehr regelmäßigen Aufbau des Verknüpfungsfeldes eine hinsichtlich der Art, des Umfanges, der Komplexität und der Realisierung der umzusetzenden Schaltungen außerordentliche Flexibilität, wobei die Schaltungen durch Software spezifizierbar und leicht integrierbar sind.

Gemäß einer bevorzugten Ausführungsform der Erfindungen weisen die Zeilenleiter und die Spaltenleiter jeweils mindestens eine aktivierbare oder deaktivierbare Nahtstelle auf, an der der jeweilige Leiter in Leitersegmente unterteilt ist. Durch die Möglichkeit, die Leiter zu unter-brechen und in Segmente zu unterteilen, ergibt sich eine optimale Ausnutzung der in dem Verknüpfungsfeld vorhandenen Verknüpfungskapazität, eine hohe Verarbeitungsgeschwindigkeit und die Möglichkeit, logische Funktionen an beliebigen Stellen innerhalb des Verknüpfungsfeldes zu realisieren.

Die Vielfalt der innerhalb des Verknüpfungsfeldes realisierbaren Funktionen läßt sich noch dadurch erhöhen, daß zwischen Segmenten eines Leiters und/oder sich kreuzender Leiter insbesondere signalinvertierende Übergangsstellen, im folgenden Invertierungsstellen genannt, angeordnet sind, die aktivierbar oder deaktivierbar und/oder unidirektional oder bidirektional ausgebildet sein können. An diesen Invertierungsstellen wird ein Schaltzustand im funktionalen Sinne von einem Leiter oder einem Leitersegment auf einen anderen Leiter bzw. ein anderes Leitersegment in der Form übertragen, daß eine logische Invertierung des Signals stattfindet.

Der erfindungsgemäße Baustein kann so ausgebildet sein, daß die Kreuzungspunkte mit je zwei Kopplungselementen, die Nahtstellen und die Übergangsstellen homogen über das Verknüpfungsfeld verteilt sind. Unter bestimmten Voraussetzungen, d.h. im Hinblick auf bestimmte zu realisierende Funktionen ist es jedoch auch möglich, in bestimmten Bereichen des Verknüpfungsfeldes beispielsweise sämtliche Kreuzungsstellen mit je zwei Kopplungselementen zu versehen, während in anderen Bereichen nur je ein Kopplungselement pro Kreuzungspunkt vorgesehen ist. Ebenso kann es zur Realisierung bestimmter Funktionen sinnvoll sein, in bestimmten Teilen des Verknüpfungsfeldes mehr Nahtstellen und/oder Invertierungsstellen vorzusehen als in anderen Bereichen, um einerseits eine möglichst gute Ausnutzung der vorhandenen Verknüpfungsmöglichkeiten zu erreichen und andererseits den Overhead, d.h. die Schaltungsteile, die nur zum Programmieren und zum Testen der Schaltungen benötigt werden, möglichst gering zu halten.

Die folgende Beschreibung erläutert in Verbindung mit den beigefügten Figuren die Erfindung anhand eines Ausführungsbeispieles. Es zeigen:

Fig. 1    eine schematische Darstellung eines herkömmlichen Logik-Arrays mit WIRED-NOR-Funktion

Fig. 2    einen schematisch dargestellten Ausschnitt aus einem erfindungsgemäßen Verknüpfungsfeld mit WIRED-NOR-Funktion und

Fig. 3    eine schematische Draufsicht auf eine erfindungsgemäße integrierte Schaltung mit zusätzlichen Schaltungsteilen.

Die Schaltungsteile, die zur Aktivierung/Deaktivierung bzw. zum Programmieren des Verknüpfungsfeldes bzw. seiner Elemente dienen, sind nicht dargestellt. Sie sind nicht Gegenstand der Erfindung und sind einem Fachmann bekannt. Auf eine besondere Darstellung von aktivierten bzw. deaktivierten Elementen wurde verzichtet. Somit sind die Figuren als schematische Darstellungen zu verstehen.

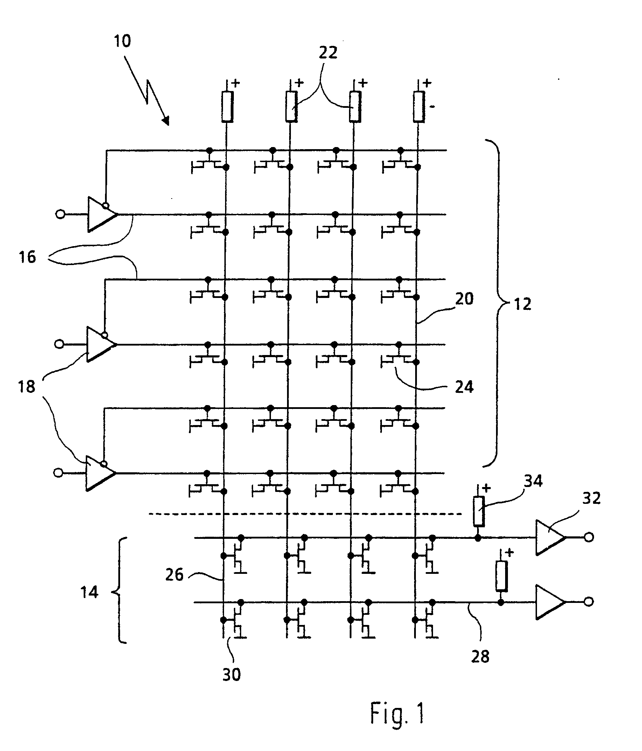

In Fig. 1 erkennt man ein allgemein mit 10 bezeichnetes Verknüpfungsfeld, bestehend aus einem UND-Array 12 und einem ODER-Array 14. Das UND-Array 12 umfaßt horizontale Leiter oder Zeilenleiter 16, die jeweils paarweise mit dem nichtinvertierenden und dem invertierenden Ausgang eines Eingangstreibers 18 verbunden sind, sowie vertikale Leiter oder Spaltenleiter 20. Die oberen Enden der Spaltenleiter 20 sind mit als PULL-UP-Elementen wirkenden Widerständen 22 verbunden.

An jedem Kreuzungspunkt zwischen Zeilenleitern 16 und Spaltenleitern 20 befindet sich ein Kopplungselement 24. Die Kopplungselemente 24 sind im vorliegenden Beispiel von Transistoren gebildet, deren Gate-Elektrode über eine Aktivierungseinrichtung mit dem jeweiligen Zeilenleiter verbunden ist. Tritt an dem betreffenden Zeilenleiter 16 ein Signal auf, so werden die mit ihm verbundenen Transistoren leitend geschaltet, so daß auf dem mit dem betreffenden Transistor verbundenen Spaltenleiter 20 die Spannung abfällt. Man erkennt, daß im vorliegenden Ausführungsbeispiel am unteren Ende des Spaltenleiters 20 nur dann ein positives Spannungssignal vorhanden ist, wenn auf keinem der Zeilenleiter 16, die über ein aktiviertes Kopplungselement 24 mit dem jeweiligen Spaltenleiter 20 verbunden sind, ein positives Signal vorhanden ist. Durch eine geeignete Programmierung, d.h. durch eine Aktivierung/Deaktivierung bestimmter Kopplungselemente 24 lassen sich somit auf den Spaltenleitern 20 definierbare Verknüpfungen herstellen, im vorliegendem Falle WIRED-NOR-Verknüpfungen der Zeilenleitersignale aktivierter Kopplungselemente.

Das ODER-Array 14 umfaßt sich unmittelbar an die Spaltenleiter 20 des UND-Arrays 12 anschließende Spaltenleiter 26 und horizontale Zeilenleiter 28. An den Kreuzungspunkten zwischen den Spaltenleitern 26 und den Zeilenleitern 28 befinden sich wiederum Kopplungselemente 30, die jedoch bezüglich ihrer Wirkungsrichtung um 90° gedreht sind. Die Zeilenleiter 28 des ODER-Arrays 14 sind mit Ausgangstreibern

3

32 und Widerständen 34 verbunden, die als PULL-UP-Elemente wirken. Man erkennt, daß die an den Ausgängen der Spaltenleiter 20 des UND-Arrays 12 vorhandenen Signale in einer durch die Programmierung, d.h. Aktivierung/Deaktivierung der Kopplungselemente 30 festgelegten Weise auf den Zeilenleitern 28 des ODER-Arrays 14 in vergleichbarer Weise verknüpft werden. Auch hier wird eine WIRED-NOR-Verknüpfung durchgeführt, allerdings von komplexeren Signalen. Insgesamt ist diese zweistufige NOR-NOR-Verknüpfung einer UND-ODER-Verknüpfung äquivalent, wie folgendes Beispiel zeigen möge:

In der NOR-NOR-Technik Funktion wird die

$$\overline{\overline{(A + B)} + \overline{(\bar{A} + C)}} = (\bar{A} \cdot \bar{B}) + (A \cdot \bar{C})$$

realisiert.

Durch entsprechende Zuordnung der Ausgänge der Eingangstreiber 18 und invertierender Ausgangstreiber 32 ist also die Äquivalenz zu einer UND-ODER-Verknüpfung gewährleistet. Das herkömmliche Verknüpfungsfeld 10 umfaßt also zwei unterschiedlich ausgebildete Bereiche 12 und 14, mit denen sich für jeden Ausgang durch passende Aktivierung/Deaktivierung der Kopplungselemente 24 bzw. 30 beliebige Verknüpfungen der Eingangssignale darstellen lassen. Insbesondere bei größeren Eingangszahlen und größeren Verknüpfungsfeldern müssen i.a. gruppenweise wenige Eingangssignale besonders intensiv miteinander verknüpft werden, während zwischen diesen Gruppen nur eine vergleichsweise lose Kopplung besteht. Zur Darstellung solcher Verknüpfungen ist der konventionelle Aufbau gemäß Fig. 1 äußerst ineffektiv, denn entweder müssen die Verknüpfungen wegen des zweistufigen Aufbaus erweitert werden, oder es verbleiben Bereiche innerhalb des Verknüpfungsfeldes, die nicht genutzt werden können. Alle für die Darstellung dieser Funktion eigentlich nicht benötigten Elemente werden somit nicht ausgenutzt und im Grunde verschenkt. Diese Redundanzen erhöhen nicht nur die Laufzeiten auf dem Chip, weil für die Darstellung der logischen Funktion eigentlich unnötig lange Leiterbahnen bzw. unnötig viel Verknüpfungen benutzt werden, sondern verursachen aufgrund der unnötigen Größe des Verknüpfungsfeldes unnötige Kosten.

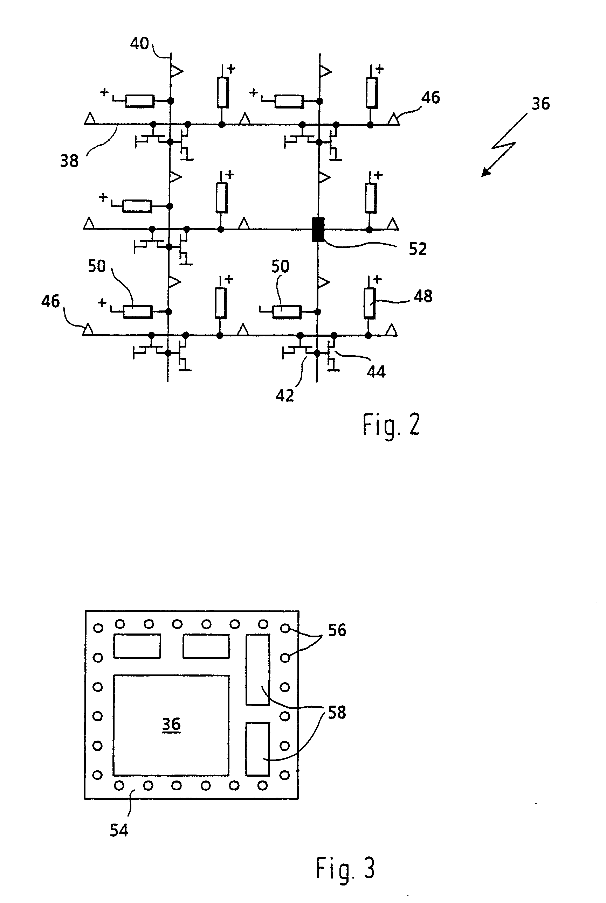

Im Gegensatz zu dem zweiteiligen Aufbau des in Fig. 1 dargestellten Verknüpfungsfeldes 10 weist das in Fig. 2 ausschnittsweise dargestellte erfindungsgemäße Verknüpfungsfeld 36 über seine gesamte Fläche hin einen einheitlichen Aufbau auf. Die Zeilenleiter 38 und die Spaltenleiter 40 des Verknüpfungsfeldes 36 sind an ihren Kreuzungsstellen jeweils durch zwei Kopplungselemente 42 bzw. 44 mit um 90° gegeneinander versetzter Wirkungsrichtung verbunden. Somit kann an jeder Kreuzungsstelle durch die Aktivierung oder Deaktivierung eines der beiden Kopplungselemente 42, 44 entschieden werden, ob an dieser Stelle eine Kopplung in vertikaler Richtung im Sinne einer UND-Verknüpfung oder in horizontaler Richtung im Sinne einer ODER-Verknüpfung erfolgen soll. Die Aktivierung oder Deaktivierung der Kopplungselemente 42, 44 kann dabei in herkömmlicher Weise erfolgen. Bei dem Verknüpfungsfeld 36 ist somit die Trennung in zwei Teilfelder unterschiedlicher Funktion aufgehoben.

Zwischen je zwei Kreuzungsstellen weisen die Zeilenleiter 38 und die Spaltenleiter 40 vorzugsweise bidirektionale Nahtstellen 46 auf, an denen die Leiter 38, 40 vorzugsweise programmierbar unterbrochen werden können. Jedes der dadurch gebildeten oder herstellbaren Leitersegmente ist mit einem als PULL-UP-Element dienenden Widerstand 48 bzw. 50 verbunden.

Eine Kreuzungsstelle des Verknüpfungsfeldes 36 ist als Übergangsstelle 52 ausgebildet. An dieser Übergangsstelle wird ein Schaltzustand im funktionalen Sinne von einem Leiter bzw. einem Leitersegment vorzugsweise in der Form auf den kreuzenden Leiter bzw. das kreuzende Leitersegment übertragen, daß eine logische Invertierung des Signals stattfindet. Es können selbstverständlich mehrere Invertierungsstellen über das Verknüpfungsfeld verteilt vorgesehen sein.

Mit der soweit beschriebenen Anordnung gemäß Fig. 2 läßt sich zum einen ein normaler Logik-Array-Aufbau variabler Größe und Lage nachvollziehen, indem jeweils nur das entsprechende Kopplungselement 42 oder 44 einer aktiven Kreuzungsstelle aktiviert wird bzw. von der Unterbrechungsmöglichkeit durch die Nahtstellen, also Leitungsmultiplex, Gebrauch gemacht wird. Die Anordnung nach Fig. 2 ermöglicht jedoch auch die Bildung von Elementen, die mit einem herkömmlichen Logik-Array nicht darstellbar sind. So stellt beispielsweise ein Kreuzungspunkt ein RS-Flip-Flop dar, wenn beide Kopplungselemente 42 und 44 aktiviert werden. Durch die wahlweise Segmentierung der Leiter 38 und 40 durch Auftrennen derselben an den Nahtstellen 46, sind nicht nur Gatter beliebiger Größe, Funktion (UND, NOR, ODER) und Lage möglich, sondern auch komplexere Gebilde wie D-Flip-Flops oder Halbaddierer, Multiplexer usw. Außerdem ergibt sich dadurch die Möglichkeit, innerhalb des Arrays eine Verdrahtung, d.h. das Weiterleiten eines Signals innerhalb des Arrays vorzunehmen. Damit lassen sich innerhalb des an sich regelmäßigen Aufbaus des Verknüpfungsfeldes Schaltungsteile mit unregelmäßigem Aufbau realisieren, insbesondere auch mehrstufige Logik. Außerdem kann mit vergleichsweise wenig Nahtstellen 46 innerhalb eines Verknüpfungsfeldes auch ein mehrstufiger Aufbau von herkömmlichen Verknüpfungsfeldern nachempfunden werden. Das ermöglicht eine sehr effektive Ausnutzung des Verknüpfungsfeldes, weit besser als bei herkömmlichen, so daß auch komplexere Logik in dieser Form dargestellt werden kann.

Die Übergangsstellen 52 haben vorwiegend die Funktion, Signale im logischen Sinne zu invertieren. Bei dem in Fig. 2 gezeigten Realisierungsbeispiel geschieht dies am einfachsten durch eine direkte (metallische) Verbindung. Denn die Übergänge über die Kopplungselemente 42 bzw. 44 sind im vorliegenden Beispiel invertierend, so daß durch einen direkten Übergang zwischen den sich kreuzenden Leitungen eine logische Invertierung eines Eingangssignales auf einer zur Eingangsleitung parallelen Ausgangsleitung erfolgt. Dieser Übergang ist bidirektional. Durch die Nahtstellen 46 in der Umgebung können ggf. Nachteile dadurch vermieden werden. Andererseits können auch Treiber eingesetzt werden, die unidirektional und signalregenerierend arbeiten.

Der Problematik langer Laufzeiten, die bei MOS-Technologien aufgrund von Lastkapazitäten entsteht, kann man mit dem erfindungsgemäßen Verknüpfungsfeld auf zweierlei Art begegnen. Zum einen kann man von einem Leitersegment auf ein in gleicher Richtung verlaufendes Leitersegment wechseln, wobei die regenerierende Wirkung der Kopplungselemente ausgenutzt wird. Zum anderen kann man Leiter in das Verknüpfungsfeld einfügen, die mit vergleichsweise wenig Kopplungselementen verbunden sind, so daß die parasitären Kapazitäten kleingehalten werden.

Bei anwendungsspezifischen integrierten Schaltkreisen gibt es viele Fälle, in denen bestimmte komplexe Funktionen, wie beispielsweise Arithmetic Logic Units, RAMs, ROMs, Multiplizierer usw. mit spezifischen Schaltungen umgeben werden müssen. Damit die Anzahl der Anschlußpins, der Schaltungs-Overhead (d.h. die Schaltungsteile, die nur zum Programmieren oder Testen des integrierten Schaltkreises benötigt werden) und die Verzögerungszeiten gering bleiben, sollten alle Funktionen auf einem Substrat untergebracht sein, wie es in Fig. 3 schematisch dargestellt ist. Entlang der Ränder des Substrats 54 sind die Anschlußpins 56 angeordnet. Neben dem Verknüpfungsfeld 36 sind auf dem Substrat 54 mehrere Schaltungsblöcke 58 vorgesehen. Dabei handelt es sich um fest verdrahtete funktionsmäßig festgelegte Logikelemente mit vorzugsweise komplexer Funktionalität. Im vorliegenden Beispiel kann das Verknüpfungsfeld 36 eingesetzt werden, um die Blöcke 58 für Anwendungen spezifisch zu verdrahten und dabei zusätzlich noch Verknüpfungen vorzunehmen und/oder diese zu steuern. Andererseits kann man einen oder mehrere der Blöcke 58 zur Unterstützung der Funktion des Verknüpfungsfeldes 36 einsetzen.

Je nach Herstellungs- bzw. Programmierungsverfahren bieten sich einige Wege an, die erfindungsgemäße Struktur den Erfordernissen anzupassen. Bei einer Maskenprogrammierung, bei der die personalisierende Verdrahtungsmaske bzw. -masken entsprechend der jeweiligen Aufgabe individuell hergestellt wird, ist es nicht explizit erforderlich, Nahtstellen und Leiterbahnen mit wenigen angeschlossenen Kopplungselementen vorzusehen. Ein Programmieroverhead ist nicht erforderlich. Bei einer nach der vollständigen Fertigung des Bausteines erfolgenden elektrischen Programmierung (Schmelzen von Soll-Trennsteinen, EPROM-, EEPROM-, RAM-Verfahren und dergleichen) bleibt normalerweise ein großer Teil der Elemente unbenutzt. Das erfindungsgemäße Verknüpfungsfeld bietet die Möglichkeit zur freien Plazierung von logischen Funktionen. Dadurch ergibt sich eine gute Ausnutzung des Verknüpfungsfeldes.

Im allgemeinen läßt sich digitale Logik, die in einem IC integriert wird, in bestimmte Funktionsgruppen einteilen, so z.B. UND-Verknüpfungen (Decoder) von Eingangssignalen, komplexere Verknüpfungen dieser Terme (z.B. Speicherung) und Ausgangssignale, die auf ODER-Verknüpfungen basieren. Deshalb kann man ohne wesentliche Einbußen an Funktionalität die Homogenität und Flexibilität des Verknüfungsfeldes einschränken und damit Redundanzen (insbesondere Programmieroverhead) abbauen, wenn man in geeigneter Weise vorgeht. Der Programmieroverhead entsteht ja dadurch, daß jede Programmierstelle (maximal vier je Kreuzungspunkt) von außen individuell ansprechbar sein muß. Evtl. kann man dabei zur Verringerung des Programmieroverheads mit einem Spannungsmultiplex arbeiten.

Eine Einschränkung der Homogenität und Flexibilität des Verknüpfungsfeldes erfolgt beispielsweise dadurch, daß man bereichs- oder segmentweise an Kreuzungspunkten nur ein Kopplungselement und/oder nicht zwischen je zwei Kreuzungspunkten eine Nahtstelle vorsieht, wobei die einzelnen Kopplungselemente in verschiedenen Bereichen mit verschiedener Wirkungsrichtung angeordnet sein können. Es ist leicht ersichtlich, daß hierbei verschiedene Kombinationen möglich sind, indem man beispielsweise im Bereich der externen Eingänge vorwiegend UND-Funktionen, im Bereich der Ausgänge vorwiegend ODER-Funktionen und dazwischen beliebige Funktionen, z.B. auch Möglichkeiten für Registerfunktionen vorsieht. Das kann beispielsweise durch folgenden Aufbau des Verknüpfungsfeldes erfolgen:

a) Eingangsseitig wird ein Bereich gebildet, dessen Kreuzungspunkte vorwiegend nur mit einem in UND-Richtung ausgerichteten Kopplungselement versehen sind und der wenig Nahtstellen, aber viele Invertierungsstellen aufweist.

b) Ein mittlerer Bereich des Verknüpfungsfeldes weist einen Bereich auf, dessen Kreuzungspunkte jeweils zwei Kopplungselemente aufweisen, wobei zwischen nahezu allen Kreuzungspunkten Nahtstellen vorgesehen sind, um beispielsweise Speicherelemente bilden zu können.

c) Ausgangsseitig ist ein Bereich vorgesehen, dessen Kreuzungspunkte wiederum vorwiegend nur ein in ODER-Richtung ausgerichtetes Kopplungselement aufweisen und der wenige Nahtstellen und einige Invertierungsstellen besitzt.

Das vorstehend beschriebene Beispiel stellt nur eine Möglichkeit der Gestaltung des erfindungsgemäßen Verknüpfungsfeldes dar. Es sind ferner Kombinationen mehrerer erfindungsgemäßer Verknüpfungsfelder auf einem Substrat denkbar, die auch unterschiedlich strukturiert sein können. Selbstverständlich können die erfindungsgemäßen Verknüpfungsfelder auch mit konventionellen Verknüpfungsfelder auf einem Substrat angeordnet sein.

Aufgrund der innerhalb des Verknüpfungsfeldes vorgesehen Invertierungsstellen ist es nicht erforderlich, Eingangssignale in invertierter und nicht invertierter Form dem Verknüpfungsfeld zuzuführen. Dadurch können im allgemeinen Leiter und Leitersegmente eingespart werden (vgl. Fig. 1).

Die Art und Ausführung von Inhomogenitäten bzw. die Lage von Invertierungsstellen und Nahtstellen innerhalb des Verknüpfungsfeldes ist u.a. abhängig von der Art der umzusetzenden Logik. Bei busorientierter Logik (für die Datenverarbeitung) werden bevorzugt parallele Anordnungen mit regelmäßigem Aufbau und bei Random-Logik (Schaltungsteile mit unregelmäßigem Aufbau) bevorzugt viele Nahtstellen und Kopplungselemente mit verschiedenen Orientierungen eingesetzt.

Mit dem erfindungsgemäßen Aufbau des Verknüpfungsfeldes wird die Möglichkeit geschaffen, anwendungsspezifische integrierte Schaltungen herzustellen, welche die gesamte Breite dieses Marktes abdecken. Sie reicht vom einfachen anwenderprogrammierbaren Schaltkreis bis zu komplexen Strukturen, deren Grenzen durch das technisch Machbare gegeben sind. Ein besonderer Vorteil der erfindungsgemäßen Lösung liegt dabei darin, daß für sämtliche Anwendungsfälle die gleiche Entwicklungssoftware benutzt werden kann. Dabei können auch Makro-Elemente definiert und eingebracht werden. Die Art der umzusetzenden Schaltung spielt dabei nur eine untergeordnete Rolle. Ferner besteht die Möglichkeit, anwenderprogrammierbare Schaltkreise als Prototypen für maskenprogrammierte Schaltkreise zu verwenden bzw. diese zu evaluieren. Maskenprogrammierte Schaltkreise lohnen nur bei hohen Stückzahlen und sind bei sehr komplexen Strukturen zwingend. Die Technologie, in der die Schaltkreise hergestellt werden, spielt ebensowenig eine Rolle wie die Frage, ob die Schaltkreise dynamisch oder statisch betrieben werden.

## Patentansprüche

1.  In integrierter Technik hergestellter Baustein zur Erstellung integrierter Schaltungen mit mindestens einem auf einem Substrat ausgebildeten programmierbaren matrixförmigen Verknüpfungsfeld mit Zeilenleitern (38) und Spaltenleitern (40), bei denen im Bereich mindestens eines Teiles ihrer jeweiligen Kreuzungspunkte der logische Zustand eines Leiters (38, 40) den logischen Zustand eines kreuzenden Leiters (40, 38) über ein Kopplungselement (42, 44) beeinflußt, dadurch **gekennzeichnet**, daß innerhalb des Verknüpfungsfeldes (36) mindestens einem Teil der Kreuzungspunkte jeweils zwei aktivierbare oder deaktivierbare Kopplungselemente (42, 44) derart zugeordnet sind, daß das eine Kopplungselement abhängig vom logischen Zustand des Zeilenleiters (38) den logischen Zustand des kreuzenden Spaltenleiters (40) und das andere Kopplungselement abhängig vom logischen Zustand des Spaltenleiters (40) den logischen Zustand des Zeilenleiters (38) beeinflussen kann.

2.  Baustein nach Anspruch 1, dadurch **gekennzeichnet**, daß die Zeilenleiter (38) und Spaltenleiter (40) jeweils mindestens eine aktivierbare oder deaktivierbare Nahtstelle (46) aufweisen, an der der jeweilige Leiter (38, 40) in Leitersegmente unterteilbar ist.

3.  Baustein nach Anspruch 1 oder 2, dadurch **gekennzeichnet**, daß zwischen Segmenten eines Leiters und/oder sich kreuzender Leiter (38, 40) im logischen Sinn nichtinvertierende Übergangsstellen (52) vorgesehen sind.

4.  Baustein nach einem der Ansprüche 1 bis 3, dadurch **gekennzeichnet**, daß zwischen Segmenten eines Leiters und/oder sich kreuzender Leiter (38, 40) im logischen Sinne signalinvertierende Übergangsstellen (52) vorgesehen sind.

**5.** Baustein nach Anspruch 4,dadurch **gekennzeichnet,** daß die Übergangsstellen (52) bidirektional ausgebildet sind.

**6.** Baustein nach Anspruch 4 oder 5, dadurch **gekennzeichnet,** daß die Übergangsstellen (52) aktivierbar oder deaktivierbar ausgebildet sind.

**7.** Baustein nach einem der Ansprüche 1 bis 6, dadurch **gekennzeichnet,** daß die Kreuzungspunkte mit je zwei Kopplungselementen (42, 44), die Nahtstellen (46) und/oder die Übergangsstellen (52) homogen über das Verknüpfungsfeld (36) verteilt sind.

**8.** Baustein nach einem der Ansprüche 1 bis 7, dadurch **gekennzeichnet,** daß entlang der Ränder des Verknüpfungsfeldes (36) aktive Elemente mit erweiterter logischer Funktion ausgebildet sind.

**Claims**

**1.** Component, manufactured using integrated technology, for producing integrated circuits with at least one programmable matrix-like interconnection field formed on a substrate with row conductors (38) and column conductors (40), in which, in the area of at least one part of their respective crossing points, the logical state of a conductor (38, 40) influences the logical state of a crossing conductor (40, 38) via a coupling element (42, 44), characterized in that within the interconnection field (36) in each case two activatable or de-activatable coupling elements (42, 44) are allocated to at least one part of the crossing points in such a way that one coupling element, depending on the logical state of the row conductor (38), can influence the logical state of the crossing column conductor (40) and the other coupling element, depending on the logical state of the column conductor (40), the logical state of the row conductor (38).

**2.** Component according to claim 1, characterized in that the row conductors (38) and column conductors (40) in each case have at least one activatable or de-activatable interface (46) at which the respective conductor (38, 40) is divisible into conductor segments.

**3.** Component according to claim 1 or 2, characterized in that junction (52), signal-inverting in the logical sense, are provided between segments of a conductor and/or of crossing conductors (38, 40).

**4.** Component according to one of claims 1 to 3, characterized in that junctions (52), signal-inverting in the logical sense, are provided between segments of a conductor and/or of crossing conductors (38, 40).

**5.** Component according to claim 4, characterized in that the junctions (52) are designed to be bi-directional.

**6.** Component according to claim 4 or 5, characterized in that the junctions (52) are designed to be activatable or de-activatable.

**7.** Component according to one of claims 1 to 6, characterized in that the crossing points with, in each case, two coupling elements (42, 44), the interfaces (46) and/or the junctions (52) are uniformly distributed over the interconnection field (36).

**8.** Component according to one of claims 1 to 7, characterized in that, along the edges of the interconnection field (36), active elements are formed with expanded logical function.

**Revendications**

**1.** Composant réalisé en technique intégrée pour la production de circuits intégrés comprenant au moins un réseau programmable d'opérations logiques en forme de matrice, formé sur un substrat et comprenant des conducteurs de ligne (38) et des conducteurs de colonne (40), dont l'état logique d'un conducteur (38, 40) agit à l'emplacement d'au moins une partie de chacun de leurs points de croisement sur l'état logique d'un conducteur (40, 38) croisant le précédent au moyen d'un élément de couplage (42, 44), caractérisé en ce qu'à l'intérieur du réseau (36) d'opérations logiques, deux éléments de couplage (42, 44) susceptibles d'être activés ou désactivés sont affectés chacun à au

7

moins une partie des points de croisement de telle manière que l'un des éléments de couplage puisse agir en fonction de l'état logique du conducteur de ligne (38) sur l'état logique du conducteur de colonne (40) croisant le précédent et que l'autre élément de couplage puisse agir en fonction de l'état logique du conducteur de colonne (40) sur l'état logique du conducteur de ligne (38).

2. Composant selon la revendication 1, caractérisé en ce que chacun des conducteurs de ligne (38) et des conducteurs de colonne (40) comprend au moins une interface (46) susceptible d'être activée ou désactivée et sur laquelle le conducteur (38, 40) correspondant peut être subdivisé en segments.

3. Composant selon la revendication 1 ou 2, caractérisé en ce que des jonctions (52) ne produisant pas d'inversion au sens logique sont prévues entre des segments d'un conducteur et/ou de conducteurs (38, 40) se croisant.

4. Composant selon l'une des revendications 1 à 3, caractérisé en ce que des jonctions produisant une inversion de signal au sens logique sont prévues entre des segments d'un conducteur et/ou de conducteurs se croisant (38, 40).

5. Composant selon la revendication 4, caractérisé en ce que les jonctions (52) sont bi-directionnelles.

6. Composant selon la revendication 4 ou 5, caractérisé en ce que les jonctions (52) sont susceptibles d'être activées ou désactivées.

7. Composant selon l'une des revendications 1 à 6, caractérisé en ce que les points de croisement avec chacun deux éléments de couplage (42, 44), les interfaces (46) et/ou les jonctions (52) sont reparties de manière homogène par le réseau de fonctions logiques (36).

8. Composant selon l'une des revendications 1 à 7, characérisé en ce que des éléments actives ayant une fonction logique élargie sont formés le long des bords du réseau.

Fig. 1

Fig. 2

Fig. 3